# EUROPEAN PATENT SPECIFICATION

(11) **EP 2 477 468 B1**
(45) Date of publication and mention of the grant of the patent: **07.03.2018**
(21) Application number: 11186471.6
(22) Date of filing: 25.10.2011
(51) Int. Cl.: H05K 13/08, G05B 19/418

(54) **Substrate inspection system**
Substratinspektionssystem
Système d'inspection d'un substrat

(30) Priority: 18.01.2011 JP 2011008266
(43) Date of publication of application: 18.07.2012
(73) Proprietor: Omron Corporation, Kyoto-shi, Kyoto 600-8530 (JP)
(72) Inventor: Matsushita, Akira, Kyoto, Kyoto 600-8530 (JP); Mori, Hiroyuki, Kyoto, Kyoto 600-8530 (JP); Kawata, Akihiro, Kyoto, Kyoto 600-8530 (JP); Yoshida, Masaomi, Kyoto, Kyoto 600-8530 (JP)
(74) Representative: Horn Kleimann Waitzhofer Patentanwälte PartG mbB

(56) References cited:
- JP-A- H08 292 241
- US-A1- 2003 125 895

## Description

### TECHNICAL FIELD

The present invention relates to a technique for generating, for each of a plurality of types of inspection machines disposed on a mounting line for substrates on which components are mounted, inspection information necessary for inspecting a substrate that is to be inspected by the inspection machine.

### RELATED ART

A substrate on which components are mounted is generally produced through a solder cream print process, a component mounting process, and a reflow process. Recently, there is a production line that includes a substrate inspection system, in which an appearance inspection machine is provided for each process, and the results of the inspection performed by the inspection machines are accumulated in an information processing apparatus, such that the inspection results for the same inspection target can be confirmed comprehensively (e.g., see Patent Document 1).

Also, there is a conventional inspection machine in which a standard inspection program called "library data" is registered for each component type, the position and the component type of each component are recognized based on the design information of the substrate to be inspected, and the inspection program corresponding to the component type of the component is allocated to the mounting position of the component, thereby efficiently generating inspection information (e.g., see Patent Document 2).
JP H08 292241 A relates to an apparatus and method for outputting inspection execution data wherein the inspection execution data can be changed easily.
US2003/125895 A1 is concerned with selection of objects for inspection and determination of an order of inspecting operation.

### RELATED ART DOCUMENTS

### PATENT DOCUMENTS

[Patent Document 1] Japanese Patent No. 3966336
[Patent Document 2] Japanese Patent No. 3203837

### SUMMARY OF THE INVENTION

### PROBLEMS TO BE SOLVED BY THE INVENTION

The inspection machine for each process in the production site often performs inspection of a plurality of inspection items. The number of the inspection machines provided for each process is not limited to one, and there are cases in which a plurality of inspection machines are used in a single process. There are also cases in which an inspection machine that performs x-ray inspection or an inspection machine for visual inspection is provided in addition to the appearance inspection machine.

Some of the inspection items performed by these inspection machines are common to the inspection machines. However, in the conventional production line, inspection information is generated for each inspection machine, and thus there is the risk that settings are performed such that the inspection of the same inspection item is performed by a plurality of inspection machines redundantly, and the production efficiency is decreased. In contrast, it is also possible that a common inspection item is removed from the inspection items of the inspection machines, considering that the inspection item will be performed by other inspection machines, so that no inspection machine performs inspection of the inspection item.

In addition, with respect to components of the same type, there are cases in which it is better to change the inspection machine for performing inspection or the inspection standard, or to use a plurality of inspection machines depending on the mounting direction or the relation with neighboring components. However, in the conventional production line, fine checking is performed only for components determined to be defective, and no proposal has been made in which the inspection machine responsible for inspection is determined for each component.

In view of the above issues, an object of the present invention is to enable selecting an inspection means for each component of the substrate to be inspected or for each inspection item to be performed, and to enable each inspection machine to readily generate inspection information based on the selection result.

### MEANS FOR SOLVING THE PROBLEMS

A substrate inspection system of the present invention includes a plurality of types of inspection machines provided on a mounting line for a substrate on which components are mounted, and a management system that manages an operation of each inspection machine. The management system can be configured by a single computer, or a network system including a plurality of computers.

The management system includes a component type information storage means, an inspection means storage means, a component specifying means, a component processing execution means, and a menu creation means described below.

In the component type information storage means, component type information is saved, into which inspection items to be performed on components of given component types are classified according to the component types. In the inspection means storage means, for each inspection item, an inspection machine that functions as an inspection means that performs inspection of the inspection item, or a combination of inspection machines is saved. Although it is desirable that a plurality of inspection means are saved for each inspection item in the inspection means storage means, one inspection means may be saved depending on the inspection item.

The component specifying means specifies, for each component mounted on a substrate to be inspected, a position and the component type of the component. The component processing execution means executes, for each component specified by the component specifying means, processing for recognizing an inspection item to be performed on the component using the component type information saved for the component type of the component in the component type information storage means, and processing for selecting, with respect to the recognized inspection item, an inspection means that performs inspection of the inspection item using information saved in the inspection means storage means.

The menu creation means generates inspection menu information associating, for each component mounted on the substrate, the component type and position information of the component with the inspection item to be performed on the component and information indicating an inspection machine that functions as an inspection means that performs inspection of the inspection item, based on a result of processing performed by the component specifying means and the component processing execution means.

In contrast, each inspection machine includes an inspection menu input means that receives input of inspection menu information generated by the management system; an inspection program storage means in which an inspection program for the inspection items that the inspection machine can perform is saved for each component type; an inspection target recognition means that recognizes a component to be inspected by the inspection machine by analyzing the inspection menu information received by the inspection menu input means, and extracts the position and the component type of the inspection target component and an inspection item to be performed on the inspection target component from the inspection menu information; an inspection information generation means that generates inspection information necessary for inspection of the substrate to be inspected by executing, for each inspection target component, processing for reading out an inspection program that conforms to the component type of the component with respect to the inspection item to be performed on the component from the inspection program storage means and processing for associating the read out inspection program with position information of the component, by using the information extracted by the inspection target recognition means; and an inspection execution means that executes inspection using the inspection information generated by the inspection information generation means.

With the configuration described above, in the management system, the inspection means that performs inspection is selected for each component of the substrate to be inspected, or for each inspection item applied to each component, and the inspection menu information reflecting the selection result is generated. Each inspection machine receives input of the inspection menu information for all components, but it employs only the inspection menu information of a component that is an inspection target of the inspection machine, and generates inspection information using that inspection menu information and an inspection program saved in the inspection program storage means of the inspection machine.

With the processing described above, there is no risk that the same inspection item is needlessly and redundantly set in a plurality of inspection machines, or risk that a necessary inspection item is not performed in any inspection machine. Also, for components of the same type, it is possible to change the selection of the inspection machines according to the actual condition of those components. Thus, it is possible to improve both inspection efficiency and inspection accuracy.

Note that in the specifying processing performed by the component specifying means, it is desirable to use the design information of the substrate to be inspected. However, this is not a limitation, and for example, it is also possible that the position of each component is measured from the image of a model of the substrate to be inspected, and the image of the model is displayed so as to let the user designate the component type.

The selection of the inspection means for each inspection item can be performed automatically, instead of performing the selection according to a selection operation performed by the user. Also, the number of selected inspection means is not limited to one, and a plurality of inspection means may be selected for a single inspection item.

It is desirable to configure the inspection menu input means of each inspection machine as a means that loads the inspection menu information through communications with the management system. However, it is not essential to configure the management system and the inspection machines so that they can communicate with each other. For example, the inspection menu information generated by the management system may be saved in a removable storage medium, and the storage medium may be set in the inspection machines in order such that the inspection menu information is loaded.

Four preferred embodiments of the substrate inspection system will be described below. According to the invention, the management system further includes an operation means for performing an operation of selecting an inspection machine and a display means for displaying information. Also, information saved in the inspection means storage means includes inspection capability information that indicates, for each inspection item, an inspection capability of each inspection means. If there are a plurality of inspection means that can perform inspection of the inspection item recognized with respect to the component to be processed, the component processing execution means displays selection candidates indicating these inspection means on the display means together with corresponding inspection capability information, and as a result of an operation of selecting an inspection means with the operation means in this display state, selects the inspection means selected by the operation.

In the above-described embodiment, if there are a plurality of inspection means that can perform the inspection item applied to the component to be processed, it is necessary to select an inspection means by the user's operation. At the time of the selection, selection candidate indicating each inspection means and the corresponding inspection capability information are displayed. Therefore, the user can readily select the inspection means with which the inspection capability that meets the target or purpose.

In a second embodiment, the management system further includes an operation means for inputting a target for an inspection performed on the production line. Also, information saved in the inspection means storage means includes inspection capability information that indicates the inspection capability of each inspection means for each inspection item. If there are a plurality of inspection means that can perform inspection of the inspection item recognized with respect to the component to be processed, the component processing execution means selects an inspection means or a combination of inspection means having an inspection capability that meets the target that has been input with the operation means.

In the above-described second embodiment, if there are a plurality of inspection means that can perform the inspection item applied to the component to be processed, the inspection means that meets the target for the inspection input by the user can be automatically selected from among the plurality of inspection means.

Note that the target for the inspection may be input prior to the processing, or may be input when a plurality of inspection means have been extracted as selection candidates. In addition, if a plurality of types of information are set as the inspection capability information, input of a target value may be received for each information, or input of the priority order indicating the priorities of the information may be received.

In a third embodiment, the management system further includes an operation means for performing an operation of changing an inspection standard for the component to be processed performed by the component processing execution means. Also, after the inspection means that performs the inspection item recognized with respect to the component to be processed has been selected, and as a result of the operation of changing the inspection standard for the inspection item with the operation means, the component processing execution means applies the changed inspection standard to the component to be processed. The menu creation means generates inspection menu information that indicates the changed inspection standard with respect to a component to which the changed inspection standard is applied.

Furthermore, each inspection machine in the third embodiment determines, in processing for analyzing the inspection menu information performed by the inspection target recognition means, whether the changed inspection standard is applied to a component for which inspection by the inspection machine is set, and reads out, in the processing for generating inspection information performed by the inspection information generation means, an inspection program corresponding to the changed inspection standard with respect to the component to which the changed inspection standard is applied.

With the third embodiment, when the user performs an operation of changing the inspection standard for a component for which inspection accuracy may not be secured with a default inspection standard, the inspection menu information of the component indicates the changed inspection standard. The inspection machine that performs inspection according to the changed inspection standard loads an inspection program that corresponds to the inspection standard indicated by the inspection menu information. In this manner, it is possible to readily and reliably change the inspection standard.

In a fourth embodiment, with the configuration of the third embodiment, the management system further includes a design information input means that receives input of design information of the substrate to be inspected, and a display means for displaying information. Also, the component processing execution means determines an event that influences the inspection of the component to be processed by analyzing that design information received by the design information input means that relates to the component to be processed and elements around the component to be processed, displays a result of the determination on the display means, and accepts an operation of changing the inspection standard in this display state.

With the fourth embodiment, it is possible to determine the presence of an event that influences inspection such as the possibility that a shadow is generated, the mounting density of neighboring components, the mounting orientation, and the like for each component by using the design information of the substrate to be inspected, and to display the result of the determination. With this display, the user can readily understand that it is necessary to change the inspection standard, or the necessary change.

### EFFECTS OF THE INVENTION

With the present invention, in the management system, an inspection means is selected that performs inspection of each component and each inspection item, and inspection menu information is generated, the inspection menu information associating, for each component, the component type and the position information of the component with the inspection item to be performed on the component and information indicating the inspection machine that functions as an inspection means that performs inspection, and the inspection menu information is introduced to each inspection machine so as to generate inspection information specific to the inspection machine. Accordingly, there is no risk that the same inspection item is needlessly and redundantly set in a plurality of inspection machines, or risk that a necessary inspection item is not performed in any inspection machine. Also, it is possible to change details of the inspection according to the actual condition of the components.

As a result, it is possible to improve both inspection efficiency and accuracy.

### BRIEF DESCRIPTION OF THE DRAWINGS

- Fig. 1: is a block diagram illustrating a configuration of a substrate inspection system;
- Fig. 2: is a functional block diagram of an inspection program management apparatus;
- Fig. 3: is a diagram showing an example of an inspection menu setting screen;
- Fig. 4: is a diagram showing an example of a setting screen for changing an inspection means;
- Fig. 5: is a diagram schematically illustrating the data configuration of a component type table as a table;
- Fig. 6: is a diagram schematically illustrating the data configuration of inspection menu information as a table;
- Fig. 7: is a flowchart illustrating the procedure for generating the inspection menu information;
- Fig. 8: is a flowchart illustrating the procedure following FIG. 7; and
- Fig. 9: is a functional block diagram illustrating a function common to inspection machines.

### EMBODIMENTS OF THE INVENTION

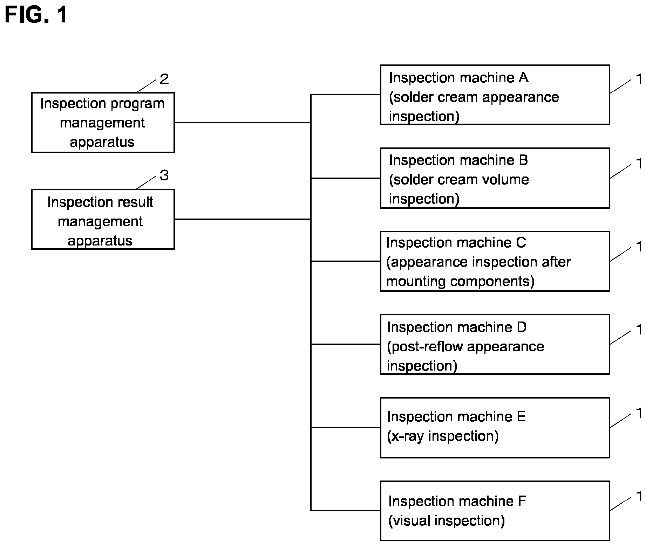

Fig. 1 shows a configuration example of a substrate inspection system to which the present invention is applied.

The substrate inspection system of this embodiment is configured by a plurality of inspection machines 1 disposed on a production line (not shown in the drawings) for substrates on which components are mounted, an inspection program management apparatus 2 that manages inspection programs used by the inspection machines 1, and an inspection result management apparatus 3 that manages the results of the inspections performed by the inspection machines 1, for example. The management apparatuses 2 and 3, and the inspection machines 1 are connected to each other through a LAN.

All six inspection machines 1 in Fig. 1 have different configurations and functions. In the description given below, the six inspection machines 1 are respectively referred to as an "inspection machine A", "inspection machine B", "inspection machine C", "inspection machine D", "inspection machine E", and "inspection machine F" in order to refer to each of the inspection machines 1, according to the description in the blocks in Fig. 1.

The production line includes a solder print process, a component mounting process and a reflow process.

The inspection machines A and B are provided in the solder print process, and inspect the print state of solder cream. Hereinafter, this inspection will be referred to as the " solder print inspection".

With respect to the solder print inspection, the inspection machine A performs appearance inspection based on two-dimensional image processing. In contrast, the inspection machine B determines the volume of solder cream on the lands of the substrate by three-dimensional measurement, and determines whether the volume is acceptable.

The inspection machine C is provided in the component mounting process, and performs an appearance inspection on the components mounted on the substrate. For example, the inspection machine C performs an inspection for checking the presence of components (hereinafter referred to as the "missing-component inspection"), and an inspection for checking displacements in the position of components (hereinafter referred to as the "component displacement inspection").

The inspection machine D is provided in the reflow process, and performs appearance inspection on the substrate after reflow.

Although the inspection machine D mainly performs an inspection of solder fillets (hereinafter referred to as the "fillet inspection"), it can also perform inspection of other inspection items.

In the fillet inspection according to a default inspection standard, light is emitted obliquely onto the component, a camera is disposed approximately right above the component, and the image of the component is captured with the optical axis of the camera oriented in the vertical direction. In this manner, an image including the specular reflection light image of the fillet portion is created, and the state of the specular reflection light image is checked. However, in cases where the inclination of the fillet is large or a shadow is generated due to an adjacent component, it is possible to change the inspection standard such that the image is captured from an oblique direction. Also, in cases where the inspection machine B performs inspection, it is possible to improve the inspection accuracy by correcting the measurement value for the fillet based on the solder volume measured during the inspection.

The inspection machine E inspects, by x-ray imaging, the inside of the components and portions at the soldering sites that are difficult to be detected by the appearance inspection with respect to the substrates that have undergone all these processes.

The inspection machine F is for performing visual inspection by inspection staff. The inspection machine F captures and displays the image of the substrate that has undergone all the processes, and the results of a quality determination (good or poor) performed by the inspection staff for each component can be entered into it.

A substrate to be inspected is conveyed along the inspection machines 1, in the order of the inspection machines A, B, C, D, E and F. Each time the substrate is transported into an inspection machine 1, that inspection machine 1 executes inspection based on the inspection program registered in advance, and sends inspection result information to the inspection result management apparatus 3. The inspection result management apparatus 3 accumulates the inspection result information received from the inspection machines 1 such that the inspection result information can be read out for each inspection machine and each inspection target individually. The inspection result information accumulated in the inspection result management apparatus 3 can be read out for confirmation at the inspection site, or used for statistical processing for productivity analysis, as appropriate.

Note that the inspection program management apparatus 2 and the inspection result management apparatus 3 are not necessarily required to be separate entities, and the functions of the management apparatuses 2 and 3 may be realized by a single computer. Conversely, each of the management apparatuses 2 and 3 may be configured by a plurality of computers. Also, it is possible to include a terminal apparatus in the system for the operation of the management apparatuses 2 and 3 and for displaying processing results.

In the present embodiment, prior to inspection, the inspection program management apparatus 2 decides the inspection item to be performed and the inspection machine for performing the inspection item for each component mounted on the substrate to be inspected, and generates inspection menu information associating the result of the decision with the position information and the component type information of the component. The inspection menu information is distributed to the inspection machines 1 all at once. Each inspection machine 1 generates inspection information of the substrate to be inspected using the distributed inspection menu information and the inspection programs for the component types that are registered in the inspection machine 1 in advance. Note that also with respect to the inspection machine F for visual inspection, it is necessary to automatically adjust the positions of the substrate and the camera, the direction of the line of sight of the camera, and the like, and inspection information for such adjustment is generated.

The inspection program management apparatus 2 that generates the inspection menu information and the processing for generating the inspection menu information will be described below in detail.

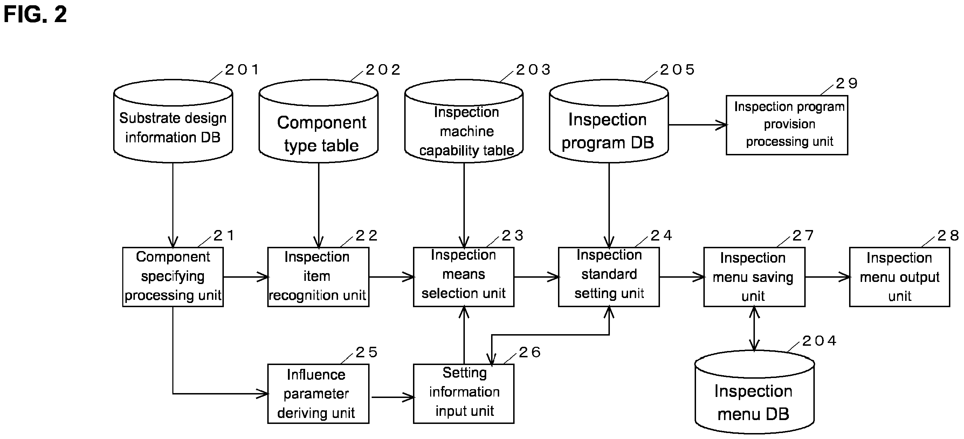

Fig. 2 is a functional block diagram of the inspection program management apparatus 2.

The inspection program management apparatus 2 includes a component specifying processing unit 21, an inspection item recognition unit 22, an inspection means selection unit 23, an inspection standard setting unit 24, an influence parameter deriving unit 25, a setting information input unit 26, and storage units indicated by reference numerals 201 to 205. The units 21 to 26 are functions set in the inspection program management apparatus 2 by programs. The storage units 201 to 205 are stored in a memory of the inspection program management apparatus 2. The number of files constituting the storage units is not limited to one, and the storage units may be configured by linking a plurality of data files.

Of the storage units, design information of the substrate to be inspected is stored in a substrate design information database 201. This design information is derived from CAD data or the like, and indicates the position information (coordinates) and the component type of each component on the substrate. Note that the component type is set by classifying various components mounted on the substrate according to the shapes, functions or the like.

Component type information that defines, for each component type, the inspection item required to be performed on components that belong to the component type is stored in a component type table 202. As described below, although the component type information of this embodiment includes default definition information that defines the inspection machine for performing inspection of each inspection item, this definition information is not essential.

Information that indicates, for each inspection item, the inspection means capable of performing inspection of the inspection item and the inspection capability thereof (hereinafter referred to as the "inspection capability information") is stored in an inspection machine capability table 203. The inspection means may be a single inspection machine 1 or a combination of a plurality of inspection machines 1. In addition, in the present embodiment, the period of time required for inspection, information that indicates cost such as power consumption, and the reliability of the inspection, each expressed in degrees, is stored as the inspection capability information. The priority described below may be stored in association with the inspection capability information.

The generated inspection menu information is stored in an inspection menu database 204 with information identifying the corresponding substrate.

An inspection program database 205 is provided for providing inspection programs that are not registered in the inspection machines 1 to the inspection machines 1. Inspection programs that may be used by the inspection machines 1 are all stored in the inspection program database 205, sorted according to the type of the inspection machines 1, the inspection items and the component types.

In response to a request from an inspection program input unit 12 (to be described below) of the inspection machine 1, an inspection program provision processing unit 29 reads out the requested inspection program from the inspection program database 205 and sends the program to the inspection machine 1 that sent the request.

The component specifying processing unit 21 reads out and analyzes the design information of a new substrate to be inspected from the substrate design information database 201, and specifies the position and the component type of each component mounted on the substrate to be inspected.

The inspection item recognition unit 22, the inspection means selection unit 23, the inspection standard setting unit 24, the influence parameter deriving unit 25, and the setting information input unit 26 create an inspection menu that is specific to the component to be processed, while processing the components specified by the component specifying processing unit 21 in order.

The inspection item recognition unit 22 reads out the component type information corresponding to the component type of the component to be processed from the component type table 202, and recognizes the inspection item to be performed on the component based on the definition thereof. The influence parameter deriving unit 25 loads and analyzes the design information of the component to be processed and elements around the component to be processed through the component specifying processing unit 21, and thereby derives parameters influencing the component to be processed.

The influence parameters are parameters for determining the presence of events that may have an influence on the inspection. For example, in order to determine the presence of a shadow, the height of or the distance from adjacent components are calculated. Also, if the sizes of the components or lands are included in the substrate design information, these are extracted as influence parameters for determining the inclination state of the fillet. Also, it is possible to calculate the density of the components around the component to be processed as an influence parameter for determining the inclination state of the fillet.

The setting information input unit 26 launches a setting screen for inputting information necessary for inspection of the component to be processed in cooperation with an operation unit and a display unit, not shown in the drawings. The setting information input unit 26 receives the information input through this screen, and forwards the information to the inspection means selection unit 23 or the inspection standard setting unit 24. The result of the influence parameter calculation is forwarded to the setting information input unit 26 and used for generating influence information described below.

When a certain inspection item is designated in the inspection menu setting screen in order to change the inspection machine defined as the inspection means, the inspection means selection unit 23 searches the inspection machine capability table 203, and the inspection means for the designated inspection item are read out with the inspection capability information corresponding thereto. Then, the inspection means selection unit 23 forwards the read out information to the setting information input unit 26, and instructs the setting information input unit 26 to present a setting change screen in which each of the inspection means is presented as a selection candidate. When one of the selection candidates is selected in this screen, the inspection means selection unit 23 updates the definition information of the inspection machine for the designated inspection item according to the selection.

The inspection standard setting unit 24 operates when an inspection item is designated in order to change the inspection standard for the inspection machine defined as the inspection means. First, the inspection standard setting unit 24 extracts all inspection standards that are applicable to the inspection of the inspection item performed on the component to be processed, with respect to the inspection machine defined for the designated inspection item. Each inspection standard is actually an inspection program file, in which title information indicating the details of the inspection standard is included. The inspection standard setting unit 24 forwards the title information in the extracted files to the setting information input unit 26, and instructs to present a screen that presents the title information as selection candidates. In this screen, when one of the selection candidates is selected, the inspection standard setting unit 24 adds the title information indicated by the selected selection candidate to the definition information of inspection machine for the designated inspection item.

As described above, an inspection menu for each component on the substrate is determined in order through the processing performed by the units 22 to 26 included in the component processing means, and thus the inspection menu information for the entire substrate is generated. This inspection menu information for the entire substrate is saved in the inspection menu database 204 by an inspection menu saving unit 27 in the inspection menu database 204, and is also forwarded to the inspection menu output unit 28. The inspection menu output unit 28 distributes the inspection menu information to the inspection machines 1 through LAN.

Next, a specific example of the setting screen presented for setting the inspection menu will be described.

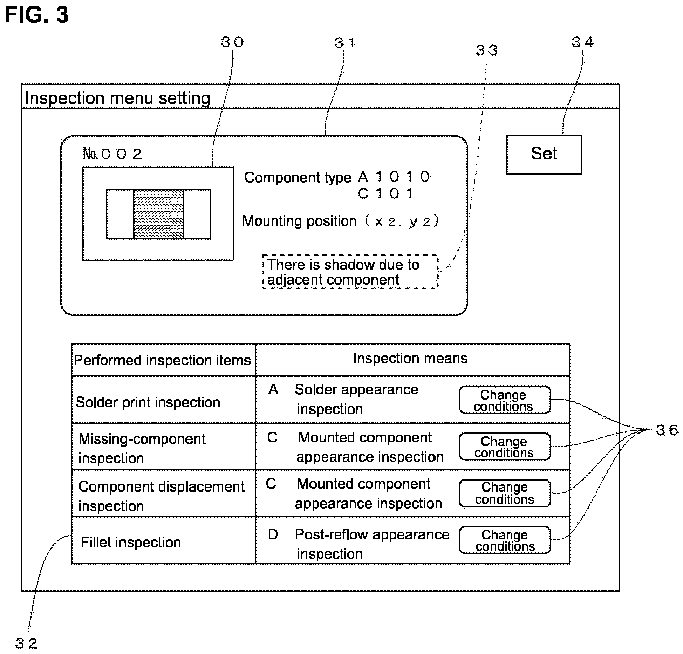

FIG. 3 is an example of the initial screen that is launched upon completion of the recognition processing with the inspection item recognition unit 22. In this screen, a sample image 30 of the component to be processed, a field 31 showing component information, and a table 32 showing the inspection items to be performed on the component to be processed and the definition information of the inspection means are displayed. In the upper right of the screen, a button 34 for indicating completion of setting is provided.

The inspection means in the table 32 is displayed according to the default definition information read out from the component type table 202. Also, in the field 31, in addition to the component type and the mounting position of the component to be processed specified by the component specifying processing unit 21, information 33 (hereinafter referred to as the "influence information 33") indicating the determination result obtained by using the aforementioned influence parameters is displayed.

In the screen described above, when an operation of designating one of the inspection items shown in the table 32 is performed, the setting screen is switched to one for selecting the inspection means for the designated inspection item.

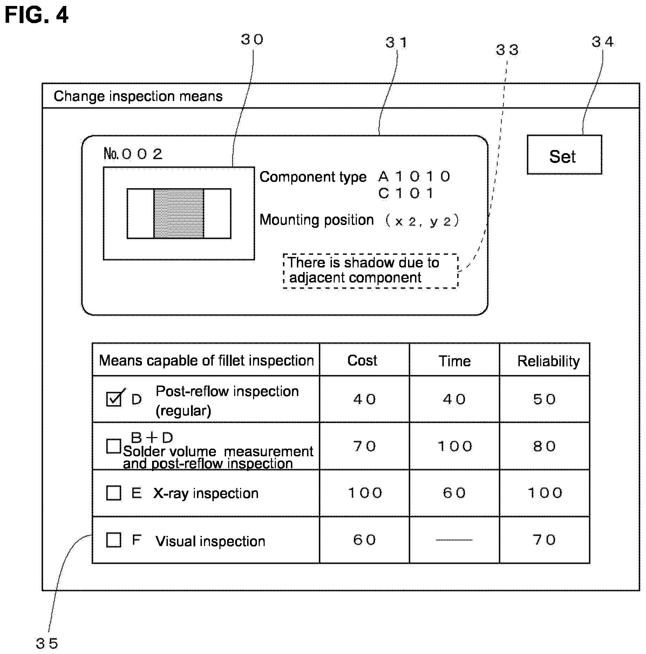

Fig. 4 is an example of the selection screen displayed as a result of designating the fourth inspection item (fillet inspection) in the table 32. Although the field 31 in the upper half of the screen is the same as that shown in Fig. 3, the table 32 is replaced by a table 35 showing the selection candidates for the inspection means.

For each selection candidate, the columns "cost", "time" and "reliability" are set in addition to the inspection means, and a predetermined value is displayed in each column (note that no value is set in the column of "time" for the visual inspection). The selection candidates, each including the inspection means and the inspection capability, are all read out from the inspection machine capability table 203.

Each selection candidate has a check box. The selection candidate that is in a selected state immediately after the selection screen has been displayed is determined according to default definition information. However, the user can change the selected selection candidate while referencing the values indicating the inspection capability, and it is also possible to select a plurality of selection candidates. When the selection is completed and the button 34 is operated, the display screen returns to the screen shown in Fig. 3. However, the display of the inspection machine in the table 32 of the inspection means corresponding to the selected inspection item (fillet inspection) is changed.

A button 36 labeled "change conditions" is provided in each row in the table 32 in the screen shown in Fig. 3. When this button 36 is operated, a selection screen (not shown in the drawings) for changing the inspection item and the inspection standard for the inspection means in the row corresponding to the operated button 36 is displayed. In this screen, all inspection standards applicable to the component to be processed are displayed. This display is configured according to the title information of the inspection programs read from the inspection program database 205.

When the user determines that it is necessary to change the inspection standard of any of the inspection items displayed on the screen shown in Fig. 3, the user clicks the button 36 of the row corresponding to that inspection item, and calls the selection screen for change described above. A desired inspection standard is selected from among the inspection standards displayed on the screen. When the selection is completed, the screen shown in Fig. 3 is displayed again.

Note that the influence information 33 in the field 31 in the screen shown in Fig. 3 can be used as an indicator for determining whether to change the inspection standard.

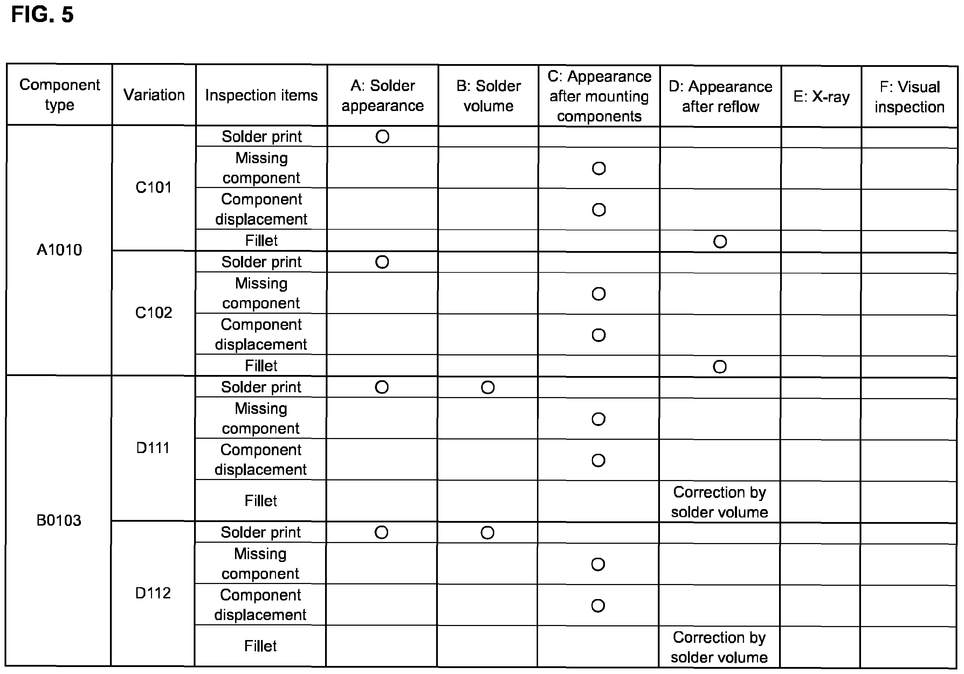

Fig. 5 shows an example of the component type information stored in the component type table 202. In this embodiment, each component type is subdivided by the unit called "variation", and the inspection items and the default definition information of inspection machines are set for each combination of the component type code and the variation code.

Note that in the description given below, in order to make the description simple, one variation is treated as one component type. Also in Fig. 5, although the inspection items for each component type are limited to four inspection items, namely, the solder print inspection, the missing-component inspection, the component displacement inspection and the fillet inspection, the inspection items are not limited to these four items. In addition, the corresponding inspection items will be different between the component types.

The specific definition information of the inspection machines is configured by a combination of flag data for the inspection machines. The flag data of the inspection machine 1 that performs inspection is set to on, and the flag data of other machines 1 is set to off. When the inspection standard of any inspection machine is changed by the inspection standard setting unit 24, the title information of the inspection standard after the change is added to the definition information of the inspection item for which the change has been made.

In Fig. 5, the columns for the inspection machines A, B, C, D, E and F are provided, and the inspection machine for which the flag data is on is indicated by a circle in the column corresponding to that inspection machine. Also, when the inspection standard of the inspection machine that performs the inspection is changed, the circle in the corresponding column is deleted, and the title information of that changed inspection standard is indicated.

In the example of Fig. 5, it is defined that with respect to the component types indicated by the first code A1010-C101 and the second code A1010-C102, the solder print inspection is performed using the inspection machine A, and the missing-component inspection and the component displacement inspection using the inspection machine C, and the fillet inspection using the inspection machine D.

Also, it is defined that with respect to the component types indicated by the third code B0103-D111 and the fourth code B0103-D112, the solder print inspection is performed using the inspection machines A and B, and the missing-component inspection and the component displacement inspection are performed using the inspection machine C, and the fillet inspection is performed using the inspection machine D. Furthermore, in these component types, it is defined that an inspection standard "correction by solder volume" is applied to the inspection machine D. This inspection standard defines to correct the measurement value obtained during the fillet inspection based on the volume of the solder cream, and determine the quality (good or poor) based on the corrected measurement value, on the assumption that the inspection machine B is used for the solder print inspection.

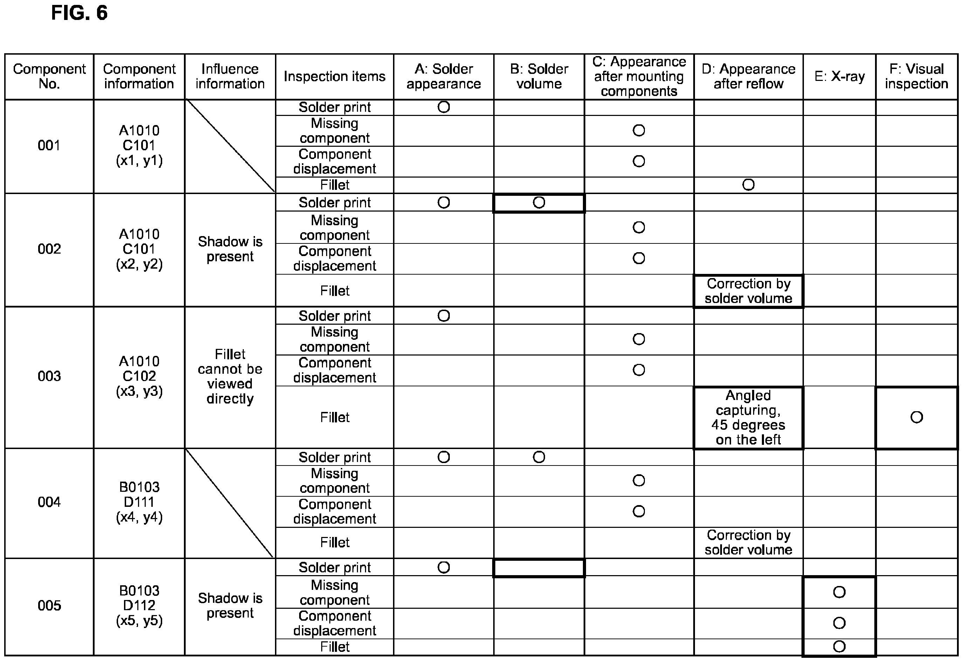

Next, Fig. 6 shows an example of the inspection menu information generated based on the stated component type information and the substrate design information. In this example, the components of the substrate to be inspected are identified by the serial number (the figures indicated in the column "component No." in Fig.6), and each component is associated with the corresponding component information, influence information, inspection item, and definition information of the inspection machine. The definition information of the inspection machine is configured, similar to that shown in Fig. 5, by the circles indicating that the flag data is in the on state, and the title information of the inspection standards. Also, in Fig. 6, the components having the component numbers 001 and 002 belong to the first component type in Fig. 5, the component having the component number 003 belongs to the second component type in Fig. 5, the component having the component number 004 belongs to the third component type in Fig. 5, and the component having the component number 005 belongs to the fourth component type in Fig. 5.

The component information of each component is derived by the processing that the component specifying processing unit 21 performs on the design information of the substrate to be inspected, and includes identification information of the corresponding component type (component type code and variation code), and coordinates indicating the positions of the components ((x1, y1), (x2, y2) and the like). Note that although in Fig. 6, the component information is limited to that of four component types shown in Fig. 5, in practice, the information of a variety of types of components is included.

The influence information is set when it is determined that there is an event that influences the inspection, based on the influence parameters derived by the influence parameter deriving unit 25. The influence information 33 in the field 31 displayed in the examples shown in Figs. 3 and 4 is derived by this processing.

The influence information "shadow is present" set for the components having the component numbers 002 and 005 means that a shadow may be generated due to an adjacent component while the appearance inspection is performed. The influence information is set, for example, when the height of the component adjacent to the component to be processed exceeds a certain threshold. Also, the influence information "fillet cannot be viewed directly" set for the component having the component number 003 indicates that the fillet is steeply inclined so that the appearance inspection may not be accurate. This influence information is set when the size of the component or the land is less than a certain threshold, or when the density of components around the component to be processed is greater than a certain threshold.

In the definition information of the inspection machines in Fig. 6, fields having a definition that is different from default information are enclosed by a bold line. In Fig. 6, although the component having the component number 001 and the component having the component number 002 are of the same component type, the default definition information indicated in Fig. 5 is applied to the component having the component number 001, and with respect to the component having the component number 002, the inspection machine B is added for the solder print inspection, and the inspection standard of the inspection machine D that performs the fillet inspection is changed to "correction by solder volume". It is possible that this change in the definition has been made as a result of the user taking the influence information "shadow is present" into account.

Note that generally, the inspection standard is changed by the inspection standard setting unit 24, and the stated change to "correction by solder volume" is presented to the user exceptionally as an inspection means realized in combination with the inspection machine B. Specifically, upon selecting the second selection candidate (a combination of the inspection machines B and D), which is shown in the second row in the table 35 shown in Fig. 4, the flag data of the inspection machine B is set to on and the inspection standard of the inspection machine D is changed.

With respect to the component having the component number 003, the inspection standard for the fillet inspection is changed to "angled capturing, 45 degrees on the left". This inspection standard means that a camera is disposed on the left of the inspection target component, and the optical axis of the camera is inclined by 45 degrees. This change in the inspection standard may have been made by an operation of changing settings that the user has performed while taking the influence information "fillet cannot be viewed directly" into consideration.

Furthermore, with respect to the definition information of the fillet inspection of the component having the component number 003, the flag data of the inspection machine F for visual inspection is also set to on. That is, the definition information has been changed such that inspection is performed by the inspection machine D with the changed inspection standard, and further, inspection by the inspection machine F is performed.

The default definition information is applied as is to the component having the component number 004. In contrast, with respect to the component having the component number 005 for which the same definition information has been set by default, the definition is changed such that the component-missing inspection, the component displacement inspection, and the fillet inspection are performed by the inspection machine E using x-rays. This change in the definition may have been made as a result of the user taking the influence information "shadow is present" into consideration.

Furthermore, with respect to the component having the component number 005, in the definition information for the solder inspections, the flag data of the inspection machine B is changed from the on state to the off state. This change may have been made as a result of the user having considered that measurement of the solder volume is not necessary since no appearance inspection of the fillet is performed.

In this manner, the user can change the inspection means or the inspection standard with respect to inspection items for which the inspection accuracy may not be guaranteed according to the default definition, while confirming the influence information. In addition, it is possible to eliminate unnecessary inspections by preventing a plurality of inspection means from being set for a single inspection item, and as illustrated with the component with the component number 003, it is also possible to select a plurality of inspection means for a single inspection item if necessary, so as to secure the inspection accuracy. In cases where the inspection means is changed, the inspection capabilities of the inspection means can be compared in terms of the cost, time and accuracy as in the example shown in Fig. 4, and the inspection machine suitable for the production purpose can be selected.

Note that when the screen in Fig. 4 is displayed, the priority for each inspection capability is decided in advance according to the user's operation of designating the priority, and combinations of the selection candidates and the degrees of the capabilities may be displayed in the descending order of the priority of the capability. In this manner, the user can select an appropriate inspection means while comparing the selection candidates displayed in the order of priorities set to the capabilities by the user.

In this embodiment, although the inspection capability information for each inspection means is stored in the inspection machine capability table 203 as fixed information, it is also possible to store the inspection capability information that differs between the component types. Also, the inspection capability information may be calculated in each case according to the component type, the mounting position and the like of the component to be processed.

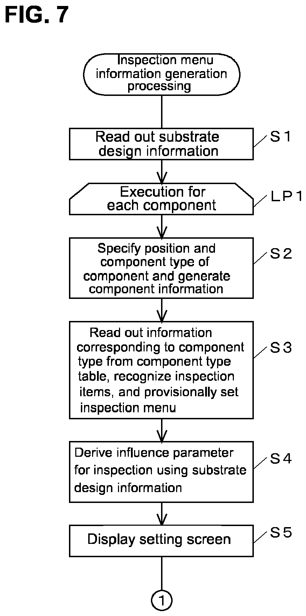

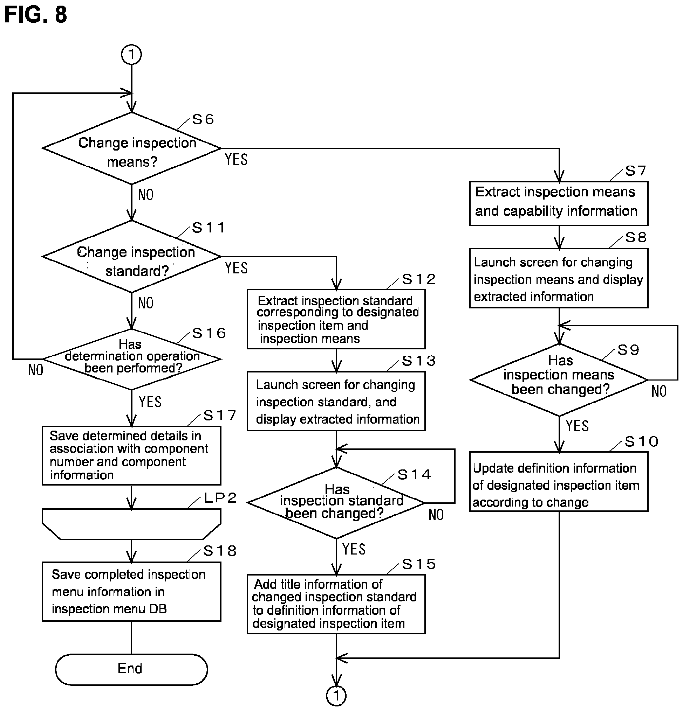

Figs. 7 and 8 show a flow of the processing for generating inspection menu information performed by the inspection program management apparatus 2.

In this processing, after the design information of the substrate to be inspected has been read out, the processing in steps S2 to S17 between the loop signs LP1 and LP2 is executed for each component indicated by the design information.

In step S2, by analyzing the substrate design information read out in step S1, the position and the component type of the component to be processed are specified, and component information including these is generated.

In step S3, the component type information corresponding to the component type specified in step S2 is read out from the component type table, and the inspection items included in the information are recognized. Also, a provisional inspection menu is generated in a working memory by using the definition information of the inspection machine that is set by default for each inspection item.

In the subsequent processing, the details of the provisional inspection menu are changed as appropriate, and finally decided.

In step S4, influence parameters for the inspection of the component to be processed are derived using the substrate design information.

In step S5, the setting screen shown in Fig. 3 is displayed. In this screen, as described above, the inspection items to be performed on the component to be processed and default definition information of the inspection machine are displayed. Also, a determination is made as to whether any event is present that may influence the inspection based on the influence parameters derived in step S4, and if it has been determined that there may be such influence, the influence information indicating the influence that may occur is generated, and is indicated in the field 31 displayed in the setting screen.

Let us now turn to Fig. 8. If an operation of designating an inspection item in order to change the definition of the inspection means is performed ("YES" in step S6) in the setting screen stated above, the inspection machine capability table 203 is checked using the designated inspection item, and the inspection means corresponding to that inspection item and the inspection capability information of the inspection means are extracted (step S7).

In step S8, the screen for changing the inspection means (the screen shown in Fig. 4) is launched, and the information extracted in step S7 is displayed. If an operation of changing the inspection means is performed in this display ("YES" in step S9), the definition information of the inspection machine for the designated inspection item is updated according to the change made through the operation (step S10).

Next, if the inspection item has been designated for changing the inspection standard ("YES" in step S11), the inspection standard corresponding to the designated inspection item and the inspection means is extracted using the inspection program database 205 (step S12). Furthermore, in step S13, the screen for changing the inspection standard is launched, and the information extracted in step S12 is displayed.

If an operation of changing the inspection standard is performed in the display stated above ("YES" in step S14), the title information of the changed inspection standard is added to the definition information of the inspection machine to be changed of the designated inspection item (step S15).

Note that if a cancellation operation has been performed in the screen for setting change in the processing in steps S6 to S10 and the processing in steps S11 to S15, or the selection candidate currently selected has been selected, the processing subsequent thereto is skipped, and the processing returns to step S6.

As described above, the processing for changing the inspection means or the inspection standard is performed as appropriate, and when the operation of ending settings for the component to be processed has been performed, "YES" is obtained as the determination result in step S16, and in step S17, the details of the inspection menu set by the processing performed thus far are saved in the memory in association with the component number and the component information. Note that since the component numbers are serial numbers, the component number are updated in series and assigned automatically.

When the inspection menu information for the entire substrate has been completed as a result of steps S2 to S17 having been executed on each component of the substrate to be inspected, the inspection menu information is saved in the inspection menu database 204 in step S18, and the processing is ended.

Note that in this embodiment, the inspection menu information for the entire substrate is generated by the user changing a default inspection menu provided for each component type as necessary. However, the method for generating the inspection menu information is not limited to this, and it is possible to generate the inspection menu information automatically or semi-automatically.

For example, operations by the user can be made unnecessary by applying default definition information to the component for which influence information has been generated, and automatically changing the inspection means or the inspection standard with respect to the component for which influence information has been generated.

It is also possible to cause the user to input a target for the inspection capability in advance, and for each component, from among the inspection means applicable for the component, the inspection means having the inspection capability closest to the target is selected. For example, an operation of setting the priorities for the respective pieces of inspection capability information, namely, cost, time and reliability, is received, and the inspection means that has the best value for the capability corresponding to the inspection capability information that has the highest priority is automatically selected. Alternatively, the result of the selection may be displayed, and the selection may be finally decided as a result of an operation of approving the displayed selection having been performed.

In addition, if no priority order is designated, a default priority order may be stored in the inspection machine capability table 203.

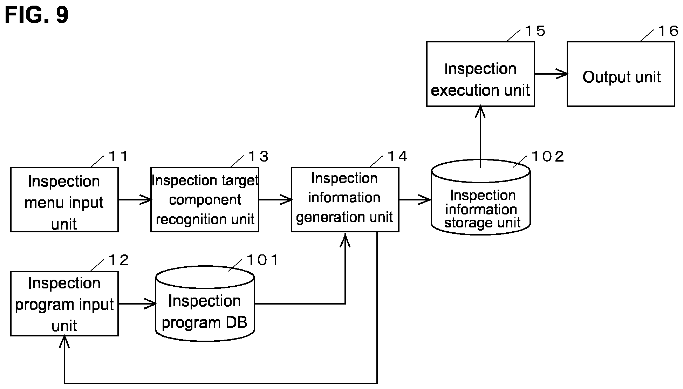

Fig. 9 is a functional block diagram showing a function common to the inspection machines 1. The processing for generating inspection information specific to each inspection machine 1 based on the inspection menu information common to the inspection machines 1 will be described below with reference to Fig. 9.

As shown in Fig. 9, each inspection machine 1 includes an inspection program database 101 and a data file configuring an inspection information storage unit 102. In each inspection machine 1, functions of an inspection menu input unit 11, an inspection program input unit 12, an inspection target component recognition unit 13, an inspection information generation unit 14, an inspection execution unit 15 and an output unit 16 are set.

The inspection menu input unit 11 receives inspection menu information sent from the inspection program management apparatus 2. The inspection target component recognition unit 13 of an inspection machine 1 extracts, as the inspection target components, components for which the flag data is set to on with respect to the inspection machine 1 based on the inspection menu information. In the extraction processing, in addition to the component information indicating the component type and the mounting position, the inspection items are also extracted. Furthermore, if title information of the inspection standard for the inspection machine 1 is included in the definition information of inspection machine, the title information is also extracted.

In the inspection program database 101, for each component type, inspection programs corresponding to the component type are stored. The inspection information generation unit 14 reads out, for each component selected by the inspection target component recognition unit 13, the inspection program corresponding to the combination of the component type and the inspection item of the component from the inspection program database 101, and associates the program with the mounting position of the component. In this case, generally, an inspection program based on the default inspection standard is read out. However, if the title information of the inspection standard is included in the information extracted with regard to the component to be processed, the inspection program based on the inspection standard corresponding to the title information is read out.

Also, if the necessary inspection program is not stored in the inspection program database 101, the inspection information generation unit 14 notifies the inspection program input unit 12 of the fact. The inspection program input unit 12 accesses the inspection program management apparatus 2 upon this notice, and receives the necessary inspection program from the inspection program provision processing unit 29 shown in Fig. 2.

By the series of processing described above, it is possible for an inspection machine 1 to read out, for all components for which it is defined in the inspection menu information to perform inspection by the inspection machine 1, an inspection program that conforms to the set inspection standard, and to associate the inspection program with the position information of the corresponding component.

The combination of the position information and the inspection program for each component is saved in the inspection information storage unit 102, and thereafter read out by the inspection execution unit 15. The inspection execution unit 15 of an inspection machine 1 executes, based on the read out inspection program, inspection only on the components on the substrates for which inspection by the inspection machine 1 is defined. This inspection result is edited by the output unit 16 as the inspection result information, and output to the inspection result management apparatus 3 or the like.

### INDEX TO THE REFERENCE NUMERALS

- 1: inspection machine
- 2: inspection program management apparatus
- 11: inspection menu input unit
- 13: inspection target component recognition unit
- 14: inspection information generation unit
- 15: inspection execution unit
- 21: component specifying processing unit
- 22: inspection item recognition unit
- 23: inspection means selection unit
- 24: inspection standard setting unit
- 25: influence parameter deriving unit
- 26: setting information input unit
- 27: inspection menu saving unit
- 28: inspection menu output unit
- 101: inspection program database
- 202: component type table
- 203: inspection machine capability table

## Claims

1. A substrate inspection system comprising:
a plurality of types of inspection machines (1) provided on a mounting line for a substrate on which components are mounted; and
a management system (2) that manages an operation of each inspection machine (1),
wherein the management system (2) comprises:
a component type information storage means into which component type information (202) is saved, said component type information (202) defines for each component type, an inspection item required to be performed on components that belong to the component type;
an inspection means storage means in which, for each inspection item, an inspection machine (1) that functions as an inspection means that performs inspection of the inspection item, or a combination of inspection machines (1) is saved;
a component specifying means (21) that specifies, for each component mounted on a substrate to be inspected, a position and the component type of the component;
a component processing execution means that executes, for each component specified by the component specifying means (21), processing for recognizing an inspection item to be performed on the component using the component type information (202) saved for the component type of the component in the component type information storage means, and processing for selecting, with respect to the recognized inspection item, an inspection means that performs inspection of the inspection item using information saved in the inspection means storage means; and
a menu creation means that generates inspection menu information associating, for each component mounted on the substrate, the component type and position information of the component with the inspection item to be performed on the component and information indicating an inspection machine (1) that functions as an inspection means that performs inspection of the inspection item, based on a result of processing performed by the component specifying means (21) and the component processing execution means, and
each inspection machine (1) comprises:
an inspection menu input means (11) that receives input of inspection menu information generated by the management system (2);
an inspection target recognition means (13, 22) that recognizes a component to be inspected by the inspection machine (1) by analyzing the inspection menu information received by the inspection menu input means (11), and extracts the position and the component type of the inspection target component and an inspection item to be performed on the inspection target component from the inspection menu information;
an inspection information generation (14) means that generates inspection information necessary for inspection of the substrate to be inspected by executing, for each inspection target component, processing for reading out an inspection program that conforms to the component type of the component with respect to the inspection item to be performed on the component from the inspection program storage means and processing for associating the read out inspection program with position information of the component, by using the information extracted by the inspection target recognition means; and
an inspection execution means (15) that executes inspection using the inspection information generated by the inspection information generation means (14),
**characterised in that** each inspection machine further comprises an inspection program storage means (102) in which an inspection program for the inspection items that the inspection machine (1) can perform is saved for each component type; and **in that** the management system (2) further comprises an operation means for performing an operation of selecting an inspection machine (1) and a display means for displaying information,
information saved in the inspection means storage means includes inspection capability information that indicates, for each inspection item, an inspection capability of each inspection means, and
if there are a plurality of inspection means that can perform inspection of the inspection item recognized with respect to the component to be processed, the component processing execution means displays selection candidates indicating these inspection means on the display means together with corresponding inspection capability information, and as a result of an operation of selecting an inspection means with the operation means in this display state, selects the inspection means selected by the operation.

2. The substrate inspection system according to claim 1,
wherein the management system (2) further comprises an operation means for inputting a target for an inspection performed on the production line,
information saved in the inspection means storage means includes inspection capability information (203) that indicates the inspection capability of each inspection means for each inspection item, and
if there are a plurality of inspection means that can perform inspection of the inspection item recognized with respect to the component to be processed, the component processing execution means selects an inspection means or a combination of inspection means having an inspection capability that meets the target that has been input with the operation means.

3. The substrate inspection system according to claim 1,
wherein the management system (2) further comprises an operation means for performing an operation of changing an inspection standard for the component to be processed performed by the component processing execution means,
after the inspection means that performs the inspection item recognized with respect to the component to be processed has been selected, and as a result of the operation of changing the inspection standard for the inspection item with the operation means, the component processing execution means applies the changed inspection standard to the component to be processed,
the menu creation means generates inspection menu information that indicates the changed inspection standard with respect to a component to which the changed inspection standard is applied, and
each inspection machine (1) determines, in processing for analyzing the inspection menu information performed by the inspection target recognition means, whether the changed inspection standard is applied to a component for which inspection by the inspection machine (1) is set, and reads out, in the processing for generating inspection information performed by the inspection information generation means (14), an inspection program corresponding to the changed inspection standard with respect to the component to which the changed inspection standard is applied.

4. The substrate inspection system according to claim 3,
wherein the management system (2) further comprises a design information input means that receives input of design information of the substrate to be inspected, and a display means for displaying information, and
the component processing execution means determines an event that influences the inspection of the component to be processed by analyzing that design information received by the design information input means that relates to the component to be processed and elements around the component to be processed, displays a result of the determination on the display means, and accepts an operation of changing the inspection standard in this display state.

## Patentansprüche

1. Leiterplattenprüfsystem, aufweisend:
mehrere Arten von Prüfmaschinen (1), die an einer Bestückungsstrasse für Leiterplatten, auf denen Bauteile montiert werden, vorgsehen sind; und
ein Managementsystem (2), das einen Betrieb jeder Prüfmaschine (1) managt, wobei das Managementsystem (2) Folgendes aufweist:
ein Speichermittel für Bauteiltypinformationen, in welchem Bauteiltypinformationen (202) abgespeichert sind, wobei die Bauteiltypinformationen (202) für jeden Bauteilyp einen Prüfgegestand definieren, der an den Bauteilen dieses Bauteiltyps durchgeführt werden muss;
ein Speichermittel für Prüfmittel, in welchem, für jeden Prüfgegestand eine Prüfmaschine (1), die als Prüfmittel zur Prüfung des Prüfgegestands dient, oder eine Kombination von Prüfmaschinen (1) gespeichert ist;
ein Bauteilangabemittel (21), welches für jedes auf einer zu prüfenden Leiterplatte bestückte Bauteil eine Position und den Bauteiltyp des Bauteils angibt;
ein Bauteilverarbeitungsausführungsmittel, welches für jedes durch das Bauteilangabemittel (21) angegebene Bauteil eine Verarbeitung zur Erkennunung eines Prüfgegestands, der an dem Bauteil durchgeführt werden soll, unter Verwendung der für den Bauteiltyp des Bauteils im Speichermittel für Bauteiltypinformationen abgespeicherten Bauteiltypinformationen,
sowei eine Verarbeitung zur Auswahl, hinsichtlich des erkannten Prüfgegestands, eines Prüfmittels, das die Prüfung des Prüfgegenstands durchführt, unter Verwendung der im Speichermittel für Prüfmittel gespeicherten Informationen, durchführt;
ein Menüerzeugungsmittel, das Prüfmenüinformationen erzeugt, die für jedes auf der Leiterplatte bestückte Bauteil den Bauteiltyp und Positionsinformationen des Bauteils mit dem am Bauteil durchzuführenden Prüfgegenstand sowie Informationen, die eine Prüfmaschine (1) angeben, die als Prüfmittel zur Durchführung der Prüfung des Prüfgegenstands dient, verknüpft, und zwar auf Basis eines Ergebnisses der mit dem Bauteilangabemittel (21) durchgeführten Verarbeitung; und
jede Prüfmaschine (1) Folgendes aufweist:
ein Prüfmenüeingabemittel (11), das eine Eingabe von Prüfmenüinformationen enpfängt, die durch das Managementsystem (2) erzeugt wurden;
ein Prüfobjekterkennungsmittel (13, 22), das durch Analyse der Prüfmenüinformationen, die von dem Prüfmenüeingabemittel (11) erhalten wurden, ein mit der Prüfmaschine (1) zu prüfendes Bauteil erkennt, und die Position und den Bauteiltyp des zu prüfenden Bauteils sowie einen am zu prüfenden Bauteil durchzuführenden Prüfgegenstand aus den Prüfmenüinformationen extrahiert;
ein Prüfinformationserzeugunsmittel (14), zum Erzeugen von Prüfinformationen, die für die Prüfung der zu prüfenden Leiterplatte notwendig sind, und zwar durch Ausführen, für jedes zu prüfende Bauteil, einer Verarbeitung zum Auslesen eines Prüfprogramms, das mit dem Bauteiltyp des Bauteils hinsichtlich des am Bauteil durchgeführten Prüfgegenstands übereinstimmt, aus dem Prüfprogrammspeichermittel, und eine Verarbeitung zum Verknüpfen des ausgelesenen Prüfprogramms mit Informationen über die Position des Bauteils, und zwar unter Verwendung der mit dem Prüfobjekterkennungsmittel extrahierten Informationen; und
ein Prüfungsausführungsmittel (15) zum Ausführen einer Prüfung unter Verwendung der mit dem Prüfinformationserzeugunsmittel (14) erzeugten Informationen,
**dadurch gekennzeichnet, dass** jede Prüfmaschine ein Prüfprogrammspeichermittel (102) aufweist, in welchem für jeden Bauteiltyp ein Prüfprogramm für die Prüfgegenstände, die die Prüfmaschine (1) durchführen kann, gespeichert ist;
das Managementsystem (2) ferner ein Betriebsmittel zum Durchführung eines Betriebs zur Auswahl einer Prüfmaschine (1) und ein Anzeigemittel zur Anzeige von Informationen aufweist,
die im Speichermittel für Prüfmittel gespeicherten Informationen Informationen umfassen, die für jedes Prüfmittel eine Prüffähigkeit angeben, und
falls mehrere Prüfmittel vorliegen, die die Prüfung des für das zu verarbeitende Bauteil erkannten Prüfgegenstands durchführen können, dann zeigt das Bauteilverarbeitungsausführungsmittel auf dem Anzeigemittel Auswahlkandidaten, die diese Prüfmittel angeben, zusammen mit ensprechenden Prüffähigkeitsinformationen an, und als Ergebnis einer Auswahl eines Prüfmittels mit dem Betriebsmittel in diesem Anzeigezustand, wählt das Bauteilverarbeitungsausführungsmittel das durch die Auswahl ausgewählte Prüfmittel aus.

2. Leiterplattenprüfsystem gemäß Anspruch 1,
wobei das Managementsystem (2) ferner ein Betriebsmittel zur Eingabe einer an der Bestückungsstrasse durchzuführenden Prüfung aufweist,
die in dem Speichermittel für Prüfmittel gespeicherten Informationen Prüffähigkeitsinformationen (203) umfassen, die die Prüffähigkeit jedes Prüfmittels für jeden Prüfgegenstand angeben, und
falls es mehrere Prüfmittel gibt, die eine Prüfung des für das zu verarbeitenden Bauteil erkannten Prüfgegenstand durchführen können, dann wählt das Bauteilverarbeitungsausführungsmittel ein Prüfmittel oder eine Kombination von Prüfmitteln aus, die eine Prüffähigkeit aufweisen, die das mit dem Betriebsmittel eingegebene Ziel erfüllt.

3. Leiterplattenprüfsystem gemäß Anspruch 1,
wobei das Managementsystem (2) ferner ein Betriebsmittel aufweist zum Durchführen eines Betriebs zum Ändern eines Prüfstandards für das durch das Bauteilverarbeitungsausführungsmittel zu verarbeitende Bauteil aufweist,
das Bauteilverarbeitungsausführungsmittel den geänderten Prüfstandard auf das zu verarbeitende Bauteil anwendet, nachdem das Prüfmittel, das den für das zu verarbeitende Bauteil erkannten Prüfgegenstand durchführt ausgewählt wurde, und als Ergebnis der Änderung des Prüfstandards für den Prüfgegenstand mit dem Betriebsmittel,
das Menüerzeugungsmittel Prüfmenüinformationen erzeugt, die den geänderten Prüfstandard anzeigen für ein Bauteil, auf das der geänderte Prüfstandard angewandt wurde, und
jede Prüfmaschine in der Verarbeitung zur Analyse der Prüfmenüinformationen durch das Prüfobjekterkennungsmittel bestimmt, ob der geänderte Prüfstandard auf ein Bauteil angewandt wird, für welches die Prüfung durch die Prüfmaschine (1) eingestellt wurde, und in der Verarbeitung zur Erzeugung von Prüfinformationen mit dem Prüfinformationserzeugunsmittel (14) ein Prüfprogram ausliest, welches dem geänderten Prüfstandard für das Bauteil, auf das der geänderte Prüfstandard angewandt wird, entspricht.

4. Leiterplattenprüfsystem gemäß Anspruch 3,
wobei das Managementsystem (2) ferner ein Designinformationeingabemittel zum Empfangen einer Eingabe von Designinformationen für das zu prüfende Substrat, und ein Anzeigemittel zur Anzeige von Informationen aufweist; und
das Bauteilverarbeitungsausführungsmittel ein Ereignis bestimmt, welches die Prüfung des zur verarbeitenden Bauteils bestimmt, und zwar durch Analyse der mit dem Designinformationeingabemittel empfangenen Designinformationen, die das zu verarbeitende Bauteil betreffen, sowie Elementen um das zu verarbeitende Bauteil herum, welches ein Ergebnis dieser Bestimmung auf dem Anzeigemittel anzeigt, und eine Änderung des Prüfstandards in diesem Anzeigezustand annimmt.

## Revendications

1. Système d'inspection de substrat, comprenant :
une pluralité de types de machines d'inspection (1) disposées sur une chaîne de montage d'un substrat sur lequel sont montés des composants ; et
un système de gestion (2) qui gère un fonctionnement de chaque machine d'inspection (1),
dans lequel le système de gestion (2) comprend :
un moyen de stockage d'informations de types de composants dans lequel sont enregistrées des informations de types de composants (202), lesdites informations de types de composants (202) définissent pour chaque type de composant, un point d'inspection qu'il est nécessaire d'effectuer sur des composants qui appartiennent au type de composant ;
un moyen de stockage de moyens d'inspection dans lequel, pour chaque point d'inspection, une machine d'inspection (1) qui fait office de moyen d'inspection qui effectue l'inspection du point d'inspection, ou une combinaison de machines d'inspection (1) est enregistrée ;
un moyen de spécification de composant (21) qui spécifie, pour chaque composant monté sur un substrat à inspecter, une position et le type de composant du composant ;
un moyen d'exécution de traitement de composant qui exécute, pour chaque composant spécifié par le moyen de spécification de composant (21), un traitement destiné à reconnaître un point d'inspection à effectuer sur le composant à l'aide des informations de type de composant (202) enregistrées pour le type de composant du composant dans le moyen de stockage d'informations de types de composants, et un traitement destiné à sélectionner, par rapport au point d'inspection reconnu, un moyen d'inspection qui effectue l'inspection du point d'inspection à l'aide d'informations enregistrées dans le moyen de stockage de moyens d'inspection ; et
un moyen de création de menu qui produit des informations de menu d'inspection associant, pour chaque composant monté sur le substrat, les informations de type de composant et de position du composant au point d'inspection à effectuer sur le composant et des informations indiquant une machine d'inspection (1) qui fait office de moyen d'inspection qui effectue l'inspection du point d'inspection, sur la base d'un résultat de traitement effectué par le moyen de spécification de composant (21) et le moyen d'exécution de traitement de composant, et chaque machine d'inspection (1) comprend :
un moyen d'entrée de menu d'inspection (11) qui reçoit en entrée des informations de menu d'inspection produites par le système de gestion (2) ;
un moyen de reconnaissance de cible d'inspection (13, 22) qui reconnaît un composant devant être inspecté par la machine d'inspection (1), en analysant les informations de menu d'inspection reçues par le moyen d'entrée de menu d'inspection (11), et extrait des informations de menu d'inspection la position et le type de composant du composant cible d'inspection ainsi qu'un point d'inspection à effectuer sur le composant cible d'inspection ;
un moyen de génération d'informations d'inspection (14) qui produit des informations d'inspection nécessaires à l'inspection du substrat à inspecter, en exécutant, pour chaque composant cible d'inspection, un traitement destiné à lire un programme d'inspection qui est conforme au type de composant du composant par rapport au point d'inspection à effectuer sur le composant, à partir du moyen de stockage de programmes d'inspection et un traitement destiné à associer le programme d'inspection lu à des informations de position du composant, en utilisant les informations extraites par le moyen de reconnaissance de cible d'inspection ; et
un moyen d'exécution d'inspection (15) qui exécute une inspection à l'aide des informations d'inspection produites par le moyen de génération d'informations d'inspection (14),
**caractérisé en ce que** chaque machine d'inspection comprend en outre un moyen de stockage de programmes d'inspection (102) dans lequel un programme d'inspection des points d'inspection que peut effectuer la machine d'inspection (1) est enregistré pour chaque type de composant ;
et **en ce que** le système de gestion (2) comprend en outre un moyen opérationnel destiné à effectuer une opération de sélection d'une machine d'inspection (1) et un moyen d'affichage destiné à afficher des informations,
les informations enregistrées dans le moyen de stockage de moyens d'inspection incluent des informations de capacité d'inspection qui indiquent, pour chaque point d'inspection, une capacité d'inspection de chaque moyen d'inspection, et
s'il existe une pluralité de moyens d'inspection qui peuvent effectuer l'inspection du point d'inspection reconnu par rapport au composant à traiter, le moyen d'exécution de traitement de composant affiche des candidats de sélection indiquant ces moyens d'inspection sur le moyen d'affichage conjointement avec des informations de capacité d'inspection correspondantes, et par suite d'une opération de sélection d'un moyen de sélection avec le moyen opérationnel dans cet état d'affichage, sélectionne le moyen d'inspection sélectionné par l'opération.

2. Système d'inspection de substrat, selon la revendication 1,
dans lequel le système de gestion (2) comprend en outre un moyen opérationnel destiné à introduire une cible pour une inspection effectuée sur la chaîne de production,
les informations enregistrées dans le moyen de stockage de moyens d'inspection incluent des informations de capacité d'inspection (203) qui indiquent la capacité d'inspection de chaque moyen d'inspection pour chaque point d'inspection, et
s'il existe une pluralité de moyens d'inspection qui peuvent effectuer l'inspection du point d'inspection reconnu par rapport au composant à traiter, le moyen d'exécution de traitement de composant sélectionne un moyen d'inspection ou une combinaison de moyens d'inspection ayant une capacité d'inspection qui répond à la cible qui a été introduite avec le moyen opérationnel.

3. Système d'inspection de substrat, selon la revendication 1,
dans lequel le système de gestion (2) comprend en outre un moyen opérationnel destiné à effectuer une opération de changement de norme d'inspection pour le composant à traiter, effectué par le moyen d'exécution de traitement de composant,
après que le moyen d'inspection qui effectue le point d'inspection reconnu par rapport au composant à traiter a été sélectionné, et par suite de l'opération de changement de la norme d'inspection pour le point d'inspection avec le moyen opérationnel, le moyen d'exécution de traitement de composant applique la norme d'inspection changée au composant à traiter,
le moyen de création de menu produit des informations de menu d'inspection qui indiquent la norme d'inspection changée par rapport à un composant auquel est appliquée la norme d'inspection changée, et
chaque machine d'inspection (1) détermine, dans un traitement destiné à analyser les informations de menu d'inspection, effectué par le moyen de reconnaissance de cible d'inspection, si la norme d'inspection changée est appliquée à un composant pour lequel une inspection par la machine d'inspection (1) est définie, et lit, dans le traitement destiné à produire des informations d'inspection, effectué par le moyen de génération d'informations d'inspection (14), un programme d'inspection correspondant à la norme d'inspection changée par rapport au composant auquel la norme d'inspection changée est appliquée.

4. Système d'inspection de substrat, selon la revendication 3,
dans lequel le système de gestion (2) comprend en outre un moyen d'entrée d'informations de conception qui reçoit en entrée des informations de conception du substrat à inspecter, et un moyen d'affichage destiné à afficher des informations, et
le moyen d'exécution de traitement de composant détermine un événement qui influe sur l'inspection du composant à traiter, en analysant celles des informations de conception reçues par le moyen d'entrée d'information de conception qui se rapportent au composant à traiter et à des éléments autour du composant à traiter, affiche un résultat de la détermination sur le moyen d'affichage, et accepte une opération de changement de la norme d'inspection dans cet état d'affichage.
